# EUROPEAN PATENT SPECIFICATION

(11) **EP 3 803 227 B1**
(45) Date of publication and mention of the grant of the patent: **06.08.2025**
(21) Application number: 19814840.5
(22) Date of filing: 05.06.2019
(51) Int. Cl.: H10N 10/00, F24H 3/02, F24H 9/20, F24H 3/06, B60H 1/22, F24H 1/06

(54) **PORTABLE HEATING SYSTEM**
TRAGBARE HEIZUNGSSYSTEME
SYSTÈME DE CHAUFFAGE PORTATIF

(30) Priority: 05.06.2018 DK PA201800258
(43) Date of publication of application: 14.04.2021
(73) Proprietor: Entiffic ApS, 4623 Lille Skensved (DK)
(72) Inventor: BANG, Mads, 9520 Skørping (DK); CHRISTENSEN, Morten Olesen, 9530 Støvring (DK); KORSGAARD, Anders Risum, 9000 Aalborg (DK)
(74) Representative: Høyer, Michael
(86) International application number: PCT/DK2019/050175
(87) International publication number: WO 2019/233538

(56) References cited:
- WO-A1-2014/161551
- WO-A1-2015/136341
- WO-A1-2015/136341
- US-A- 3 150 656
- US-A1- 2008 257 877
- US-A1- 2009 250 091
- US-A1- 2013 019 849
- US-B1- 6 307 142
- US-B1- 6 527 548
- US-B1- 7 959 657

## Description

### FIELD OF THE INVENTION

The present invention relates to a Portable Heating System (PHS).

### BACKGROUND OF THE INVENTION

A variety of portable heating systems are available for mobile applications. Most appreciated is the use of electrical heaters where access to an electrical power source in form of a grid or a battery is available. However, since the availability of an electric grid or a high capacity battery is not always granted the heat source can also be a burner that utilizes a fluid fuel for producing heat. The heat can in both embodiments be transferred from the source to the consumer via an air- or liquid- based distribution system.

When it comes to larger mobile fuel-based heating systems, they can feature not only a burner for producing heat but also an engine coupled to a generator in order to additionally provide sufficient electrical energy in order to supply the transporting system for transporting the heat from the burner to the intended place that should be heated. For example, portable heating systems may have an integrated fuel tank and a power generator with the specific purpose of providing electrical power to the system.

The transporting system for transporting the heat, can be a tubing system with a blower fan or a circulation pump depending on the transportation media for transporting the heat being based on air or water. In the following the term "fluid" will be used which will cover both air and water based transporting systems as well as other suitable medias being glycol or oil based.

Portable heating systems require to be light weight so that can be easily transported and handled. Portable heating systems may be used for climate comfort or in extreme climate conditions where heat is needed, for example cabin of a vehicle, boat cabin, tents or engine of a vehicle in extreme cold climate.

Any application of fluid fuel based portable heating systems works following the same general concept. Means as a fan or pump for forcing a heat transporting media in form of a fluid through a heat generator are used so that the transporting media is heated. To power these transportation means and to facilitate the combustion of the fuel and produce heat, electrical power is needed. Thus, portable heating systems need to be connected to an electrical power source as a battery, power generator or grid power.

The main electrical consumption in these systems depends on the fuel injection system/fuel atomization pressure, spark system and the air fan/air blower. Because of the high electrical consumption, the commercial availability of these portable heating systems is rather limited. Due to the high electrical consumption it is not possible to operate a standard portable heating system using a car battery as power source since after few hours of use the battery becomes completely depleted.

Accurate use of vehicle batteries is particularly relevant in an electric vehicle. In these vehicles, cabin heating cannot be produced by electrical heating as this would cause complete depletion of the batteries within few hours.

For these reasons alternative solutions to keep small areas heated are currently used. For example, most of the truck drivers who stop their vehicles on resting areas during the night to get rest/sleep keep the vehicle engine running in order to use the heat from the engine to heat the cabin.

This solution causes pollution of the environment and reduces the total fuel efficiency as the use of the engine for heating is rather inefficient.

Furthermore, this solution is not possible in all-electric or battery electric vehicles (BEVs) where no internal combustion engine is present.

Additionally, combustion engines, being the engine of a truck or for powering a standalone electric generator, is rather noisy and thus not very environmentally friendly and acceptable.

Alternatively, a small fluid fuel-based heating system can be installed in the cabin of the vehicle avoiding running a noisy engine and getting a better heat efficiency, e.g. between 65-70% from the fuel. This solution has the drawback that a separate battery is needed to supply enough electrical power and avoid that the battery of the vehicle gets depleted. However, even in this case, after a couple of hours of use the separate battery for the portable heating system needs to be recharged. The recharging of the battery can be obtained at the expense of the vehicle battery. Indeed, under driving conditions the vehicle generator will have to use part of the power from the engine, i.e. more fuel consumption, to charge in turn the separate battery of the portable heating system.

US3150656A discloses a heater for use in a vehicle, including a burner, a heat exchanger and thermoelectric elements. A plurality of such thermoelectric elements is arranged in series on the outer surface of the heater combustion chamber to produce an electric current.

WO2015/136341A1 discloses a fuel portable heater for heating air and introducing it into an environment to heat it. The Seebeck cells are arranged in areas of the heater that are not much exposed to the heat in an attempt to safeguard the thermoelectric elements against excess heating.

Thermoelectric elements for sure can help the problem and maintain the full charge of the battery which can make the portable heater completely independent from external electrical supplies.

Thermoelectric elements when arranged between the combustion chamber being heated by the burner and the heat exchanger makes a very compact system. However, a disadvantage is seen in that the thermoelectric elements can be damaged if the temperature on the hot side exceeds the specifications of the specific thermoelectric element. More specifically the soldering's of the thermoelectric elements will melt and damage the thermoelectric element. If this happens the thermoelectric elements will have to be exchanged. One root cause for the damage is if the combustion process is not controlled and excess temperatures are reached. Another cause can be if the produced heat is not sufficiently transferred from the combustion chamber through the thermoelectric elements and absorbed by the heat transporting media. In other words when the heat generated in the combustion chamber is not removed by the heat exchanger.

Hence, an improved portable heating system would be advantageous, which in a better way controls the production of heat and the exchange of heat from the heat exchanger in order to safeguard the thermoelectric modules.

### OBJECT OF THE INVENTION

It is an object of the invention to provide a PHS featuring thermoelectric elements where the thermoelectric elements in a better way is safeguarded against excess heating.

### SUMMARY OF THE INVENTION

As earlier stated investigations on the failure of thermoelectric elements integrated in a PHS has shown that excess heating is the major reason for failure. Thermoelectric elements are produced in a variety of types each having its own specification when it comes to the use conditions. Some are specifically developed for power generation and other for cooling purposes. Specific design choices when it comes to semiconductor material choice and doping, form and thickness of the material brings advantages and disadvantages that must be taken into consideration in the specific application. However, they all have one disadvantage in common that is solved by the solution presented hereby. The bunching of the individual PN semiconductors in thermoelectric elements are assembled to elements using a soldering technique where the soldering in general are not stable when a temperature over 320 degrees Celsius is reached. More specifically, it has been found that even though there is still a high demand for transfer of heat to the heat transporting media from the combustion chamber, the heat transfer ratio is decreasing because the heat cannot be transferred between the combustion chamber and the heat exchanger where the thermoelectric modules are arranged in-between. This is due to the specific semiconductor nature of the thermoelectric elements and the utilization of those. The heat conducting qualities of a thermoelectric element is highly influenced by the utilization of the component. Thus, when the thermoelectric element is not supplying a current, the thermal conductivity will be low and the thermoelectrical element will with its glass-like semiconductor crystal build up appear like a thermal isolating part for the forwarding of the heat to the heat transporting media. The problem is seen when the battery is fully charged and where the thermoelectric element is delivering more electric energy than absorbable by all the electrical consumers in the PHS. The electrical consumers include the electrical control, the combustion blower, the fuel pump and the means for forcing the heat transporting media, being a fan or a pump. However, if the thermoelectrical element is utilized in a way where a current is drawn, it serves like a heat pump, transferring heat between the hot and cold side proportional to the number of electrons that run or the current draw through the thermoelectric module.

Thus, the object of the invention is obtained in a first aspect of the invention by providing: a portable heating system (PHS), comprising a PHS air inlet, a combustion chamber for combustion of fuel, a burner connected to said air inlet, said burner comprising a fuel inlet for introducing fuel to said burner, a combustion blower for blowing air from the air inlet into said combustion chamber thereby allowing for production of heat by combustion of said fuel and an outlet for releasing exhaust from the combustion chamber, a heat exchanger, interfacing the combustion chamber and exchanging heat with a heat transporting media, wherein said heat exchanger is having a first side, arranged in such a way as to absorb heat from the combustion chamber and a second side for releasing heat into the heat transporting media wherein the heat exchanger further comprises at least one thermoelectric module arranged in-between the first side and second side of said heat exchanger for producing electrical effect, a rechargeable battery for absorbing the electrical power generated by the at least one thermoelectrical module where the PHS further comprises a control that is configured to monitor the electrical effect generated by the at least one thermoelectric module and configured to regulate the current draw from the at least one thermoelectric module to a level within a preset range of current draw corresponding to a preset range of thermal conductivity of the at least one thermoelectrical module by distribution of the generated electrical effect into selected electrical power consumers arranged with the PHS.

In an embodiment, the PHS further includes at least one electrical consumer wherein the control is adapted as to monitor the charging of a battery connected to be supplied with electrical energy from the at least one thermoelectric module and further to switch off the charging when a threshold voltage level on the battery defining a state of full charge has been reached and subsequently connect the thermoelectric module with one or more electrical consumers that consumes at least an amount of electrical energy that provides a good thermal conductivity of the at least one thermoelectrical module.

In a further embodiment, the PHS further includes at least one electrical consumer, wherein the control is adapted as to monitor the charging of a battery connected to be supplied with electrical energy from the at least one thermoelectric module and to provide a pulse width modulated (PWM) signal for distribution of electrical energy generated by the at least one thermoelectric module so as to by switching means provide electrical energy to the battery during a first period of the pulse width modulated signal and to by switching means provide electrical energy to an electrical consumer during a second period of the pulse width modulated signal and where the PWM ratio of the PWM signal is adjusted in response to the monitored charging level of the battery so as to absorb in total at least an amount of electrical energy that provides a good thermal conductivity of the at least one thermoelectrical module. The PWM signal thus with the pulse-pause ratio determine the charging time and the dissipation time of the electrical energy generated by the at least one thermoelectric module where it of choice can be the pulse or the pause interval that controls the charging or dissipation time. The pulse-pause length of the PWM is in an embodiment configured to be in the interval from 1 microsecond to 10 minutes. However, the specific measures depend on the design of the electronics. If the switching means is a relay, the PWM will be in the range of minutes. If the switching means is transistor based, it can be in the interval from 1 microsecond and up, depending on the slew rate of the transistor used since high frequency switching and a slow transistor will lead to high dissipation and possible destruction of the switching transistor. In an embodiment featuring transistors, the PWM pulse-pause length is configured to be between 1 (one) millisecond to 1000 milliseconds. The transistor is in an embodiment a bipolar transistor. In an embodiment, the transistor is a Field Effect Transistor (FET). In an embodiment, the transistor is a MOSFET transistor. FET type transistors feature a high slew rate and low on-resistance which avoid dissipation and destructive heat buildup in the transistor itself. Additionally, the impedance of the gate pin is high thus rendering the FET easy to control with a control signal from the controller.

In an embodiment, a thermo sensor is arranged with the rechargeable battery in order to determine the temperature of the battery.

The control is configured to determine a value of the PWM as to provide a charging current to the rechargeable battery based on the temperature of the battery and corresponding preconfigured safe charge values mapped to the temperature of the battery, the safe charge values being stored with the control.

More specifically, in embodiments of the PHS the electrical consumer is one or more resistive heating elements for dissipation of electrical power and converting the electrical power into heat.

In embodiments of the PHS, the resistive heating element is arranged in position within the PHS for heating one of the following: the air inlet; the fuel tank; the fuel pump; the fuel inlet to the fuel pump; the motor for the combustion blower; the circulation pump (if transportation media of heat is liquid based); a buffer water tank for heated water (if transportation media of heat is liquid based); the motor for the air-blower (if transportation media of heat is air based) or with the rechargeable battery.

Since the performance of especially a rechargeable battery is very temperature dependent, a temperature regulation is foreseen that only dissipates electric energy into heat in position with the described components when the supply of heat will keep the component in its ideal temperature conditions. As an example, a rechargeable battery will perform best when the temperature is between plus ten to plus 50 degrees Celsius. For a rechargeable battery dissipation of electrical energy as heat in proximity of the component should only be done when the temperature is within the ideal temperature range in order to prolong lifetime and enhance performance of the rechargeable battery. Thus, in an embodiment, the control is adapted to monitor the temperature of the rechargeable battery and in case the temperature of the rechargeable battery exceeds a predetermined value disconnect a heating element arranged with the battery to avoid excess heating of the battery.

In a special embodiment of the PHS, the electrical consumer is a clamp that serves to electrically short circuit the at least one thermoelectric module and dissipate the electrical power generated by the at least one thermoelectric module in the inner resistance of the thermoelectric module itself.

In yet another embodiment of the PHS, the control is configured to provide the motor for 1) the electric fuel pump, 2) the combustion air-blower or 3) the air-blower or 4) the circulation pump with a supply current that varies in amplitude and polarization so as to regulate the motor to inefficiency but keeping the intended velocity so as to burn electric power generated by the at least one thermoelectric module in the motor and provide heat. In this way there is no need for extra components in the form of heating elements or power resistors which helps to build a compact and cheaper PHS. A normal DC motor with brushes can be controlled in this way as well as will be the case with a brushless DC motor or a Stepper motor.

For safeguarding the at least one thermoelectrical module against heating and damage a special embodiment of the PHS is further comprising means for measuring the temperature on the hot side of the at least one thermoelectrical module where the control is adapted to monitor the temperature level on the hot side of the at least one thermoelectrical module and in case the temperature level exceeds a temperature threshold value, the control responds by increasing the current draw from the at least one thermoelectrical module until the temperature level on the hot side is beyond the temperature threshold value and in case a maximum threshold value for the current draw is reached and the temperature level still exceeds the temperature threshold value, the control further controls the fuel pump in order to decrease the amount of fluid supplied to the burner until a state is reached where the temperature level on the hot side of the at least one thermoelectrical module is not exceeding the temperature threshold value. It is understood that the regulation will need to have an inbuild latency as such as to allow the process to regulate before any further adjustment is needed. In an embodiment, the latency of regulations can be configured in the range of 1 to 60 seconds. However, the regulation latency will depend on the physical build of the PHS in order to secure that the PHS is not damaged. Thus, the threshold values for temperature values has to be chosen to match the specific type of thermoelectric module and can be maintained from consulting a data sheet.

In an embodiment that is within the scope of the invention the control is configured to, in case the temperature on the hot side of the at least one thermoelectrical module is below another threshold temperature and there is still a demand for producing heat, the control reacts by increasing the supply of fuel to the burner and thus producing more heat. The control will in such case lower the current draw to match a threshold level for current draw that has been found to give the best or a wanted efficiency of the system. However, if there is a need for charging the battery it will be appreciated if the charging current is not limited but is optimized to the current value and waveform that will in the best way charge the battery.

In yet another embodiment the PHS further comprises means for measuring the temperature in a motor for at least one of the combustion air-blower, the fuel pump (centrifugal or solenoid pump) or the heat transporting media pump (air-blower or circulation pump) and where the control is adapted to monitor the temperature level and in case the measured temperature level is below a predefined temperature threshold the control avoids the startup procedure of the PHS and supply a current from the battery to heat up the motor itself or the motor environment by dissipation of electrical energy in a heating element or by dissipation of electrical energy in the coils of the motor or the solenoid without or with limited angular rotation of the motor shaft or forth and back movements of the solenoid activation member.

For the sake of producing an efficient and environmentally friendly PHS when it comes to submission of noise the PHS is in an embodiment adapted for having multiple settings for production of heat implemented in the control. The control can be adapted for setting a specific production level of heat and for regulating the PHS to continuously keep that production level. The control can in another embodiment be adapted for regulating the PHS from feedback from a wired or wirelessly connected temperature sensor in order to provide and maintain a constant temperature at the position that is intended to be heated. The regulation can be seamless or in steps. The regulation of the produced heat will involve regulation of both the fuel pump, the combustion blower and the heat transporting media pump to mutually providing an efficient link for transferring heat from the combustion of fuel to the heat transporting media. This is done in such a way that the thermoelectrical elements are always electrically utilized in order for providing effective heat pumps for transferring the heat and producing electrical power.

The thermoelectric modules may be any commercial thermoelectric modules, i.e. commercially available components such as thermoelectric p- and n-type semiconductor legs, slices, elements or discs of any shape, or any commercially available modules with integrated p- and n-type semiconductor legs.

The first and other aspects and embodiments of the present invention may each be combined with any of the other aspects and embodiments. These and other aspects of the invention will be apparent from and elucidated with reference to the embodiments described hereinafter.

### BRIEF DESCRIPTION OF THE FIGURES

The PHS according to the invention will now be described in more detail with regard to the accompanying figures. The figures show one way of implementing the present invention and is not to be construed as being limiting to other possible embodiments falling within the scope of the attached claim set.
Figure 1, is a schematic drawing of a PAHS according to some embodiments of the invention,
Figure 2, is a top view of a PAHS according to some embodiments of the invention,
Figure 3, is a schematic drawing showing a PAHS 1 according to some embodiments of the invention with focus on the electrical features and
Figure 4, is a schematic drawing showing various scenarios for distribution of the by the TEG produced electrical energy controlled by the controller, for which the individual embodiments are shown in fig. 4a - fig. 4d.

### DETAILED DESCRIPTION OF EMBODIMENTS OF THE INVENTION

For the sake of easy explanation of the inventive concept, a portable heating system (PHS) of the type using air as the heat transportation media is hereby demonstrated. For mobile applications a portable air heating system (PAHS) is practical. However, for the use in caravans, cottages and for many other applications a liquid-based system is preferred. Thus, it is appreciated if all types of PHS is recognized to fall within the scope of the invention.

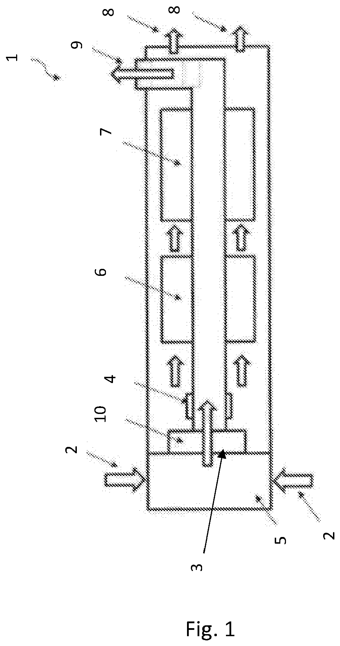

Figure 1 is a schematic drawing of a PAHS according to some embodiments of the invention. The PAHS 1 comprises one or more cabin air inlet 2, one or more combustion air inlet 3, a burner 4 connected to the combustion air inlet 3 via an air inlet chamber 5; a first heat exchanger 6 for producing electricity; a second heat exchanger 7 for increasing the temperature of the air entering the PAHS 1; one of more air outlet 8 to diffuse warm air in the vicinity of the PAHS 1; an exhaust outlet 9 to allow the release of the exhaust from the burner to the outside environment or towards a third heat exchanger.

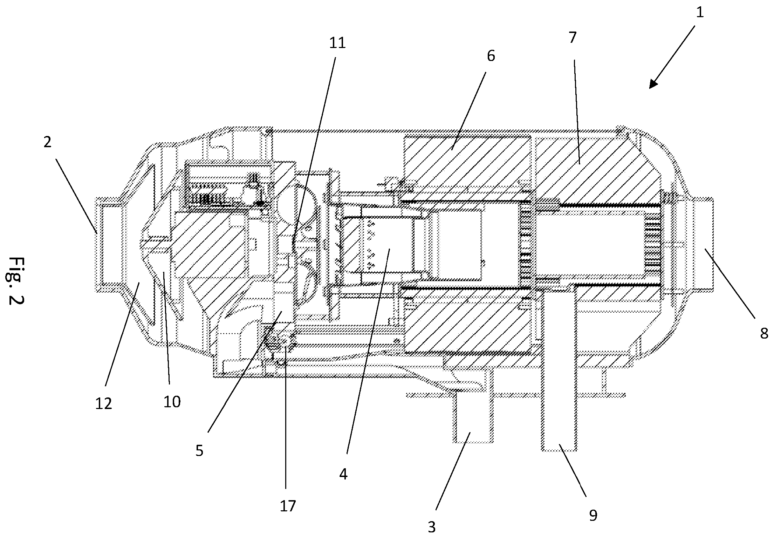

When in operation fuel is pumped towards the burner 4 though piping (not shown) and air is allowed to enter the PAHS via air inlet 2. Part of this air is directed towards the burner 4 via a burner air blower 11 (not shown in fig. 1 but shown in fig. 2). Most of the air entering the air inlet 2 is blown towards the first heat exchanger 6 by a main air fan 10. The main air fan 10 and the burner air blower 11 may be mechanically independent as well as independently powered. This configuration has the great advantage that the air flux can be optimized depending on the need of the PAHS. For example, at start the main air fan 10 does not need to blow air to be heated by the first and second heat exchanger as these exchangers are not hot as the burner has not started yet or have been just started. The burner air blower 11 on the contrary needs to blow air inside the burner so as to start the burner and produce heat. Thus, the speed and the need of the main air fan 10 and the burner air blower 11 are quite different, and the detachment of their operability optimizes their function and reduces the electricity and fuel consumption. For example, when the heat exchangers 6,7 are hot, the burner 4 can be stopped, i.e. the burner air blower 11 can also stop, while the main air fan 10 needs to blow continuously so as to take advantage of the hot heat exchangers and thus producing hot air that is released via hot air outlet 8. The fuel used may be in the liquid, gas or solid form.

Figure 2 is a top view of a PAHS 1 according to some embodiments of the invention. Figure 2 shows PAHS 1 comprising a cabin air inlet 2 allowing air to enter an air intake chamber 12. When in operation, the air in the air intake chamber 12 is blown via the main air fan 10 inside the PAHS 1 from the air intake chamber 12 towards the first heat exchanger 6 and towards the second heat exchanger 7 so as to produce hot air to be released into the vicinity of the PAHS 1 via air outlet duct 8. From the combustion air inlet 3 air is forwarded via the air inlet chamber 5 to the burner 4 via the burner air blower 11

A flue pump (not shown) ensures that fuel from a fuel tank is pumped into the burner 4 via internal piping. Heated air and exhaust from the burner exchange heat with the first heat exchanger 6 and the second heat exchanger 7 and leaves the PAHS 1 via exhaust outlet 9.

Programmed control electronics may control the burner under operation.

The burner is controlled by a flame sensor (not shown), fuel pump/metering pump (not shown), a temperature sensor (not shown) and the combustion air blower 11.

In operation by liquid fuel the burner 4 is firstly started: the electric glow wire mesh receives electrical power and start to glow. The fuel is injected onto the glowing wire mesh and also dropped partly onto the glass wool. The burner air blower 11 begins to add the necessary volume of air for combustion. The fuel over the glow wire mesh and dropped on glass wool ignites. The flame sensor senses the glowing from the flame and switch off the electric power to the glowing wire mesh. The flame from dropped fuel on glass wool superheats and evaporates the fuel in the fuel evaporator. Evaporated hot gas injects in the start flame and burns in the present of air, so that the burner 4 will run continuously.

In operation by LPG gas fuel the burner the burner 4 is firstly started: the spark plug receives high voltage electrical power from the electronic ignition system and start to ignite. The LPG fuel will be mixed with air in the primary gas-air mixer 135. The burner air blower 11 begins to add the necessary volume of air for combustion and the burner 4 will run continuously. The flame sensor works as mentioned before.

The burner is designed so that most of the hot gases will be burned at the flame outlet, which means that most of the hot gases will be burned in the first heat exchanger, i.e. the power generator. An electronic control system (not shown) adjusts the volume of the combustion air and the metering of the fuel in any condition.

Programmed control electronics may control the burner 4 under operation.

By operation with liquid fuel the burner 4 is controlled by the flame sensor, fuel pump/metering pump, temperature sensors and the combustion air blower 11.

By operation with LPG gas fuel the burner is controlled by the flame sensor, Fuel solenoid valve, self-acting thermostatic safety valve and overheat sensor.

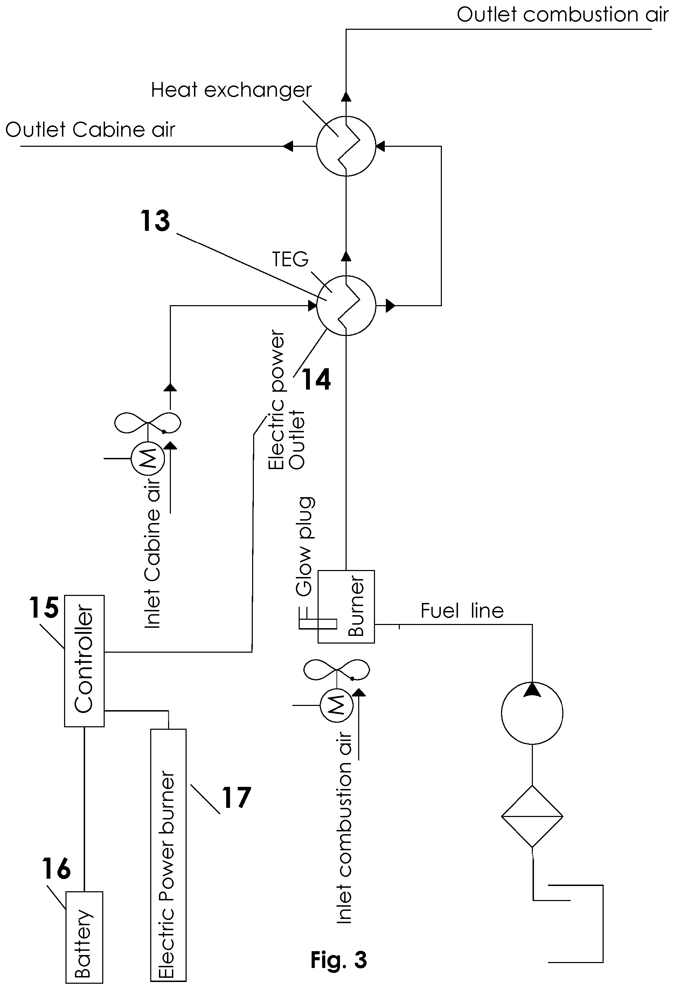

Figure 3 is a schematic drawing showing a PAHS 1 according to some embodiments of the invention with focus on the electrical features. More expediently, the first heat exchanger 6 for producing electricity features at least one thermoelectric module (TEG) 13 for producing an electric current. From the electric power outlet 14 the electric current produced is led to the controller 15 which monitors the electrical effect generated by the at least one TEG 13 and regulates the current draw from the at least one TEG 13 to a level within a preset range of current draw corresponding to a preset range of thermal conductivity of the at least one TEG 13 by distribution of the generated electrical effect into selected electrical power consumers arranged with the PAHS 1. The controller 15 monitors the battery 16 and do a recharge when needed to keep the battery 16 fully charged. When the electrical current supplied to the battery 16 decreases as the state of full charge is achieved the controller 15 distributes the surplus generated electrical energy to electrical power burners or consumers 17 arranged with the PAHS. Arranged with the PAHS does not necessarily mean fully integrated with the PAHS but also that the power consumer 17 can be arranged external to the PAHS housing. As an example, the battery 16 itself can be arranged inside or outside the PAHS housing free of choice and so as well will it be the case for other electrical power consumers 17. The reason for the controller 15 to distribute the generated electrical power and put a load on the TEG 13 is as earlier described to enable the TEG 13 to act as a thermo pump for transferring heat generated by the burner 4 through the heat exchanger 6 in order to heat the air stream from the cabin air inlet 2 forced through the PAHS with means of the main air fan 10 producing hot air that is released via hot air outlet 8. For the sake of completion, the battery can be any suitable type of battery that satisfies the specifications. The battery type should be chosen carefully with regard to the environment when it comes to performance under low temperature conditions where the battery should still be in a condition as to supply sufficient electrical energy as to start up the PAHS.

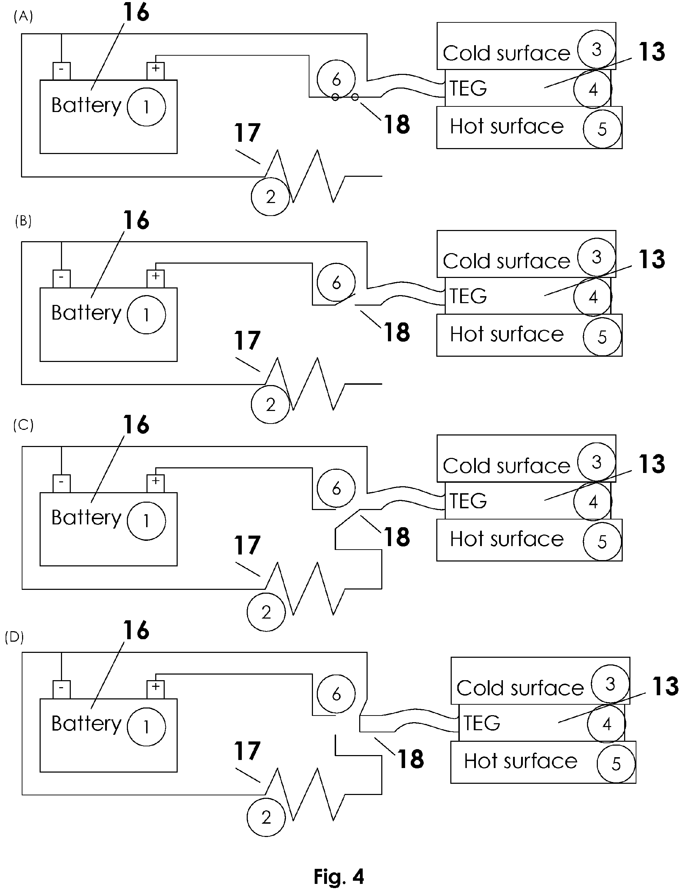

Figure 4 is a schematic drawing showing four different scenarios a - d for distribution of the by the TEG produced electrical energy controlled by the controller.

In the first embodiment showed in fig 4a, the controller 15 has closed the switch 18 in order to forward the total produced amount of electrical energy from the TEG 13 for recharging the battery 16.

The second embodiment showed in fig. 4b, shows the condition where the battery 16 is fully charged and where charging is stopped by the controller 15 by opening the switch 18. This open loop influences the PAHS heavily since the TEG 13 will not be able to work as a thermo pump using the Seebeck effect since the flow of electrons has been stopped. Thus, the thermal conductivity of the semiconductor of the TEG 13 will be lowered and provide a lower transfer ratio of heat from the burner to the heat exchanger fins. This situation should be avoided since overheating in the burner section will be subject to the TEG 13 being damaged.

In the third embodiment showed in fig. 4c, the controller 15 upon completion of charging the battery 16 the switch 18 has a third position where in the closed position it connects a power consumer 17. The power consumer is designed to take up sufficient electrical power as to enable the TEG 13 to work as a thermo pump. Referring to fig. 2 a power consumer 17 in form of a power resistor is arranged in the PAHS. Thus, the surplus electrical power generated is converted into heat which is within the spirit of the invention having the aim of producing heated air. The physical arrangement of the power consumer, here a power resistor, can as shown in fig. 2 be for heating the combustion air or the cabin air. However, power resistors can be arranged various places as e.g. for heating or evaporating the fuel, for heating the motor or fan environment, for heating the battery and will still be within the scope of the invention.

In the fourth embodiment showed in fig. 4d, the switch 18 has by the controller been put in a position to short circuit the TEG 13. Thus, the Seebeck effect is maintained and the heat produced by the TEG is dissipated in the inner resistance of the TEG itself and forwarded to the airstream.

## Claims

1. A portable heating system (PHS) (1), comprising:
- an air inlet (2,3);
- a combustion chamber for combustion of fuel;
- a burner (4) connected to said air inlet, said burner comprising a fuel inlet for introducing fuel to said burner,
- a combustion blower (11) for blowing air from the air inlet (3) into said combustion chamber thereby allowing for production of heat by combustion of said fuel and
- an outlet (9) for releasing exhaust from the combustion chamber;
- a heat exchanger (6,7), interfacing the combustion chamber and exchanging heat with a heat transporting media, wherein said heat exchanger is having:
- a first side, arranged in such a way as to absorb heat from the combustion chamber and
- a second side for releasing heat into the heat transporting media wherein the heat exchanger further comprises:
- at least one thermoelectric module (13) arranged in-between the first side and second side of said heat exchanger (6,7) for producing electrical effect;
- a rechargeable battery (16) for absorbing the electrical power generated by the at least one thermoelectrical module (13);
**Characterized in**
**that** the PHS further comprises a control (15) that is configured to monitor the electrical effect generated by the at least one thermoelectric module (13) and configured to regulate the current draw from the at least one thermoelectric module to a level within a preset range of current draw corresponding to a preset range of thermal conductivity of the at least one thermoelectrical module by distribution of the generated electrical effect into selected electrical power consumers (17) arranged with the PHS.

2. A PHS according to claim 1 further including at least one electrical consumer, wherein the control (15) is adapted as to monitor the charging of a battery (16) connected to be supplied with electrical energy from the at least one thermoelectric module (13) and further to switch off the charging when a threshold voltage level on the battery (16) defining a state of full charge has been reached and subsequently connect the thermoelectric module (13) with one or more electrical energy consumers (17) that consumes at least an amount of electrical energy that provides a good thermal conductivity of the at least one thermoelectrical module (13).

3. A PHS according to claim 1 further including at least one electrical consumer, wherein the control (15) is adapted as to monitor the charging of a battery (16) connected to be supplied with electrical energy from the at least one thermoelectric module (13) and to provide a pulse width modulated (PWM) signal for distribution of electrical energy generated by the at least one thermoelectric module so as to by switching means provide electrical energy to the battery (16) during a first period of the pulse width modulated signal and to by switching means provide electrical energy to an electrical energy consumer during a second period of the pulse width modulated signal and where the PWM ratio of the PWM signal is adjusted in response to the monitored charging level of the battery so as to absorb in total at least an amount of electrical energy that provides a good thermal conductivity of the at least one thermoelectrical module (13).

4. A PHS according to claim 3, wherein the pulse-pause length of the PWM is configured to be in the interval from 1 microsecond to 10 minutes.

5. A PHS according to claim 4, wherein the control (15) includes switching means to be controlled by the PWM for recharging a battery (16) and/or supplying a consumer (17) where the switching means is a relay.

6. A PHS according to claim 4, wherein the control (15) includes switching means to be controlled by the PWM for recharging a battery (16) and/or supplying a consumer (17) where the switching means is one of a bipolar transistor, Field Effect Transistor or a MOSFET.

7. A PHS according to claim 6, wherein the PWM pulse-pause length is configured to be between 1 (one) millisecond to 1000 milliseconds.

8. A PHS according to any of the preceding claims, wherein a thermo sensor is arranged with the rechargeable battery (16) in order to determine the temperature of the battery and give input to the control.

9. A PHS according to any of the preceding claims, wherein the control is configured to determine a value of the PWM as to provide a charging current to the rechargeable battery (16) based on the temperature of the battery (16) and corresponding preconfigured safe charge values mapped to the temperature of the battery, the safe charge values being stored with the control (15).

10. A PHS according to any of the preceding claims, wherein the electrical consumer (17) is one or more resistive heating elements for dissipation of electrical power and converting the electrical power into heat.

11. A PHS according to claim 10, wherein the resistive heating element is arranged in position within the PHS for heating one of the following:
- the air inlet (2,3);
- the fuel tank;
- the fuel pump;
- the fuel inlet to the fuel pump;
- the motor for the combustion blower (11);
- the circulation pump (if transportation media of heat is liquid based);
- a buffer water tank for heated water (if transportation media of heat is liquid based);
- the motor for the air-blower (10) (if transportation media of heat is air based);
- the rechargeable battery (16).

12. A PHS according to any of the preceding claims, wherein the control (15) is adapted to monitor the temperature of the rechargeable battery (16) and in case the temperature of the rechargeable battery exceeds a predetermined value disconnect a heating element arranged with the battery to avoid excess heating of the rechargeable battery (16).

13. A PHS according to any of the preceding claims, wherein the electrical consumer (17) is a clamp that serves to short circuit the at least one thermoelectric module (13) and dissipate the electrical power generated by the at least one thermoelectric module (13) in the inner resistance of the thermoelectric module itself.

14. A PHS according to any of the preceding claims wherein the control (15) is configured to provide the motor for 1) the electric fuel pump, 2) the combustion air-blower or 3) the air-blower or 4) the circulation pump with a supply current that varies in amplitude and polarization so as to regulate the motor to inefficiency but keeping the intended velocity so as to burn electric power generated by the at least one thermoelectric module (13) in the motor and provide heat.

15. A PHS according to any of the preceding claims, further comprising means for measuring the temperature on the hot side of the at least one thermoelectrical module (13) where the control (15) is adapted to monitor the temperature level on the hot side of the at least one thermoelectrical module (13) and in case the temperature level exceeds a temperature threshold value, the control (15) responds by increasing the current draw from the at least one thermoelectrical module until the temperature level on the hot side is beyond the temperature threshold value and in case a maximum threshold value for the current draw is reached and the temperature level still exceeds the temperature threshold value, the control (15) further controls the fuel pump in order to decrease the amount of fluid supplied to the burner (4) until a state is reached where the temperature level on the hot side of the at least one thermoelectrical module (13) is not exceeding the temperature threshold value.

## Patentansprüche

1. Tragbares Heizungssystem (PHS) (1), umfassend:
- einen Lufteinlass (2, 3);
- eine Verbrennungskammer für eine Verbrennung eines Brennstoffs;
- einen Brenner (4), der mit dem Lufteinlass verbunden ist, wobei der Brenner einen Kraftstoffeinlass zum Einleiten von Kraftstoff in den Brenner umfasst,
- ein Verbrennungsgebläse (11) zum Blasen von Luft von dem Lufteinlass (3) in die Verbrennungskammer, wodurch eine Wärmeerzeugung durch eine Verbrennung des Kraftstoffs erlaubt wird, und
- einen Auslass (9) zum Freisetzen von Abgasen aus der Verbrennungskammer;
- einen Wärmetauscher (6, 7), der eine Verbindung mit der Verbrennungskammer aufweist und Wärme mit einem Wärmetransportmedium austauscht, wobei der Wärmetauscher aufweist:
- eine erste Seite, die so angeordnet ist, dass sie Wärme aus der Verbrennungskammer absorbiert, und
- eine zweite Seite, die Wärme in das Wärmetransportmedium freisetzt, wobei der Wärmetauscher ferner umfasst:
- mindestens ein thermoelektrisches Modul (13), das zwischen der ersten Seite und der zweiten Seite des Wärmetauschers (6, 7) zum Produzieren eines elektrischen Effekts angeordnet ist;
- eine wiederaufladbare Batterie (16) zum Absorbieren der elektrischen Leistung, die durch das mindestens eine thermoelektrische Modul (13) erzeugt wird;
**dadurch gekennzeichnet**
**, dass** das PHS ferner eine Steuereinheit (15) umfasst, die konfiguriert ist zum Überwachen des elektrischen Effekts, der durch das mindestens eine thermoelektrische Modul (13) erzeugt wird, und konfiguriert ist zum Regeln der Stromaufnahme von dem mindestens einen thermoelektrischen Modul auf einen Pegel innerhalb eines voreingestellten Bereichs einer Stromaufnahme, der einem voreingestellten Bereich einer Wärmeleitfähigkeit des mindestens einen thermoelektrischen Moduls entspricht, indem der erzeugte elektrischen Effekt auf ausgewählte Verbraucher der elektrischen Leistung (17) verteilt wird, die an das PHS angeschlossen sind.

2. PHS nach Anspruch 1, das ferner mindestens einen elektrischen Verbraucher beinhaltet, wobei die Steuereinheit (15) geeignet ist zum Überwachen des Aufladens einer Batterie (16), die angeschlossen ist, um mit der elektrischen Energie von dem mindestens einen thermoelektrischen Modul (13) versorgt zu werden, und um ferner das Aufladen abzuschalten, wenn ein Schwellenspannungspegel in der Batterie (16) erreicht wurde, der den Zustand einer vollen Ladung definiert, und um nachfolgend das thermoelektrische Modul (13) mit einem oder mehreren Verbrauchern von elektrischer Energie (17) zu verbinden, die mindestens einen Großteil der elektrischen Energie verbrauchen, die von einer guten Wärmeleitfähigkeit des mindestens einen thermoelektrischen Moduls (13) bereitgestellt wird.

3. PHS nach Anspruch 1, das ferner mindestens einen elektrischen Verbraucher beinhaltet, wobei die Steuereinheit (15) geeignet ist zum Überwachen des Aufladens einer Batterie (16), die angeschlossen ist, um mit der elektrischen Energie von dem mindestens einen thermoelektrischen Modul (13) versorgt zu werden, und um ein pulsbreitenmoduliertes Signal (PWM-Signal) für eine Verteilung von elektrischer Energie bereitzustellen, die durch das mindestens eine thermoelektrische Modul erzeugt wird, um durch ein Schaltelement elektrischen Energie für die Batterie (16) während eines ersten Zeitraums des pulsbreitenmodulierten Signals bereitzustellen, und, um durch ein Schaltelement elektrische Energie für einen Verbraucher von elektrischer Energie während eines zweiten Zeitraums des pulsbreitenmodulierten Signals bereitzustellen, und wobei das PWM-Verhältnis des PWM-Signals als Reaktion auf den überwachten Ladepegel der Batterie angepasst wird, um insgesamt mindestens einen Großteil der elektrischen Energie zu absorbieren, die von einer guten Wärmeleitfähigkeit des mindestens einen thermoelektrischen Moduls (13) bereitgestellt wird.

4. PHS nach Anspruch 3, wobei die Pulspausenlänge der PWM konfiguriert ist, um in dem Intervall von 1 Mikrosekunde bis zu 10 Minuten zu liegen.

5. PHS nach Anspruch 4, wobei die Steuereinheit (15) ein Schaltelement beinhaltet, das durch die PWM gesteuert wird, um eine Batterie (16) erneut aufzuladen, und/oder um einen Verbraucher (17) zu versorgen, wobei das Schaltelement ein Relais ist.

6. PHS nach Anspruch 4, wobei die Steuereinheit (15) ein Schaltelement beinhaltet, das durch die PWM gesteuert wird, um eine Batterie (16) erneut aufzuladen, und/oder um einen Verbraucher (17) zu versorgen, wobei das Schaltelement einer von einem Bipolartransistor, einem Feldeffekttransistor oder einem MOSFET ist.

7. PHS nach Anspruch 6, wobei die PWM-Pulspausenlänge konfiguriert ist, um zwischen 1 (einer) Millisekunde und 1000 Millisekunden zu liegen.

8. PHS nach einem der vorhergehenden Ansprüche, wobei ein Wärmesensor an der wiederaufladbaren Batterie (16) angeordnet ist, um die Temperatur der Batterie zu ermitteln und eine Eingabe an die Steuereinheit abzugeben.

9. PHS nach einem der vorhergehenden Ansprüche, wobei die Steuereinheit konfiguriert ist zum Ermitteln eines Werts der PWM, um einen Ladestrom für die wiederaufladbare Batterie (16) basierend auf der Temperatur der Batterie (16) und entsprechende sichere Ladewerte, die der Temperatur der Batterie zugeordnet sind, bereitzustellen, wobei die sicheren Ladewerte in der Steuereinheit (15) gespeichert sind.

10. PHS nach einem der vorhergehenden Ansprüche, wobei der elektrische Verbraucher (17) ein oder mehrere Widerstandsheizelemente für ein Ableiten der elektrischen Leistung und ein Umwandeln der elektrischen Leistung in Wärme aufweist.

11. PHS nach Anspruch 10, wobei das Widerstandsheizelement an einer Position innerhalb des PHS zum Heizen eines der Folgenden angeordnet ist:
- des Lufteinlasses (2, 3);
- des Kraftstofftanks;
- der Kraftstoffpumpe;
- des Kraftstoffeinlasses in die Kraftstoffpumpe;
- des Motors für das Verbrennungsgebläse (11);
- der Zirkulationspumpe (wenn das Wärmetransportmedium flüssigkeitsbasiert ist);
- einen Pufferwassertank für erwärmtes Wasser (wenn das Wärmetransportmedium flüssigkeitsbasiert ist);
- des Motors für das Luftgebläse(10) (wenn das Wärmetransportmedium luftbasiert ist);
- der wiederaufladbaren Batterie (16).

12. PHS nach einem der vorhergehenden Ansprüche, wobei die Steuereinheit (15) geeignet ist zum Überwachen der Temperatur der wiederaufladbaren Batterie (16) und in dem Fall, in dem die Temperatur der wiederaufladbaren Batterie einen vorbestimmten Wert überschreitet, zum Trennen eines Heizelements, das an der wiederaufladbaren Batterie angeordnet ist, um ein übermäßiges Erwärmen der wiederaufladbaren Batterie (16) zu vermeiden.

13. PHS nach einem der vorhergehenden Ansprüche, wobei der elektrische Verbraucher (17) eine Klemme ist, die als Kurzschluss des mindestens einen thermoelektrischen Moduls (13) dient und welche die elektrische Leistung, die durch das mindestens eine thermoelektrische Modul (13) erzeugt wird, in den inneren Widerstand des thermoelektrischen Moduls selbst ableitet.

14. PHS nach einem der vorhergehenden Ansprüche, wobei die Steuereinheit (15) konfiguriert ist zum Versorgen des Motors für 1) die elektrische Kraftstoffpumpe, 2) das Verbrennungsgebläse oder 3) das Luftgebläse oder 4) die Zirkulationspumpe mit einem Versorgungsstrom, dessen Amplitude und Polarisation variiert wird, um den Motor zu einer Ineffizienz zu regeln, aber die vorgesehene Geschwindigkeit beizubehalten, um die elektrische Leistung in dem Motor zu verbrennen, die durch das mindestens eine thermoelektrische Modul (13) erzeugt wird, und um Wärme bereitzustellen.

15. PHS nach einem der vorhergehenden Ansprüche, das ferner ein Element zum Messen der Temperatur auf der heißen Seite des mindestens einen thermoelektrischen Moduls (13) umfasst, wobei die Steuereinheit (15) geeignet ist zum Überwachen des Temperaturpegels auf der heißen Seite des mindestens einen thermoelektrischen Moduls (13) und wobei in dem Fall, in dem der Temperaturpegel einen Temperaturschwellenwert überschreitet, die Steuereinheit (15) reagiert, indem die Stromaufnahme aus dem mindestens einen thermoelektrischen Modul vergrößert wird, bis der Temperaturpegel auf der heißen Seite unter dem Temperaturschwellenwert liegt, und wobei in dem Fall, in dem ein maximaler Schwellenwert für die Stromaufnahme erreicht wurde und der Temperaturpegel immer noch den Temperaturschwellenwert überschreitet, die Steuereinheit (15) ferner die Kraftstoffpumpe steuert, um die Menge des Fluids, mit dem der Brenner (4) versorgt wird, zu verringern, bis ein Zustand erreicht wird, bei dem der Temperaturpegel auf der heißen Seite des mindestens einen thermoelektrischen Moduls (13) den Temperaturschwellenwert nicht mehr überschreitet.

## Revendications

1. Système de chauffage portatif (PHS) (1), comprenant :
- une entrée d'air (2,3) ;
- une chambre de combustion pour la combustion de combustible ;
- un brûleur (4) connecté à ladite entrée d'air, ledit brûleur comprenant une entrée de combustible pour amener du combustible audit brûleur,
- un ventilateur de combustion (11) pour souffler de l'air provenant de l'entrée d'air (3) dans ladite chambre de combustion en permettant ainsi la production de chaleur par combustion dudit combustible et
- une sortie (9) pour évacuer l'échappement de la chambre de combustion ;
- un échangeur de chaleur (6,7), s'interfaçant avec la chambre de combustion et échangeant de la chaleur avec un milieu caloporteur, ledit échangeur de chaleur présentant :
- un premier côté, agencé de manière à absorber la chaleur émanant de la chambre de combustion et
- un deuxième côté pour évacuer la chaleur dans le milieu caloporteur, l'échangeur de chaleur comprenant en outre :
- au moins un module thermoélectrique (13) agencé entre le premier côté et le deuxième côté dudit échangeur de chaleur (6,7) pour produire un effet électrique ;
- une batterie rechargeable (16) pour absorber la puissance électrique générée par l'au moins un module thermoélectrique (13) ;
**caractérisé en ce que**
le PHS comprend en outre une commande (15) qui est configurée pour surveiller l'effet électrique généré par l'au moins un module thermoélectrique (13) et configurée pour réguler l'appel de courant depuis l'au moins un module thermoélectrique à un niveau s'inscrivant dans une plage prédéfinie d'appel de courant correspondant à une plage prédéfinie de conductivité thermique de l'au moins un module thermoélectrique par distribution de l'effet électrique généré dans des consommateurs de puissance électrique (17) sélectionnés agencés avec le PHS.

2. PHS selon la revendication 1, comportant en outre au moins un consommateur électrique, la commande (15) étant adaptée à surveiller la charge d'une batterie (16) connectée pour être alimentée en énergie électrique depuis l'au moins un module thermoélectrique (13) et en outre à couper la charge lorsqu'un niveau de tension seuil sur la batterie (16) définissant un état de charge complète a été atteint, et connecter consécutivement le module thermoélectrique (13) à un ou plusieurs consommateurs d'énergie électrique (17) qui consomment au moins une quantité d'énergie électrique qui assure une bonne conductivité thermique de l'au moins un module thermoélectrique (13).

3. PHS selon la revendication 1, comportant en outre au moins un consommateur électrique, la commande (15) étant adaptée à surveiller la charge d'une batterie (16) connectée pour être alimentée en énergie électrique depuis l'au moins un module thermoélectrique (13) et à fournir un signal à modulation de largeur d'impulsion (PWM) pour la distribution de l'énergie électrique générée par l'au moins un module thermoélectrique de manière à, par un moyen de commutation, fournir de l'énergie électrique à la batterie (16) durant une première période du signal à modulation de largeur d'impulsion et à, par un moyen de commutation, fournir de l'énergie électrique à un consommateur d'énergie électrique durant une deuxième période du signal à modulation de largeur d'impulsion, et le rapport PWM du signal PWM étant ajusté en réponse au niveau de charge surveillé de la batterie de manière à absorber au total au moins une quantité d'énergie électrique qui assure une bonne conductivité thermique de l'au moins un module thermoélectrique (13).

4. PHS selon la revendication 3, dans lequel la longueur de pause entre impulsions de la PWM est configurée pour s'inscrire dans l'intervalle allant de 1 microseconde à 10 minutes.

5. PHS selon la revendication 4, dans lequel la commande (15) comporte un moyen de commutation destiné à être commandé par la PWM pour recharger une batterie (16) et/ou alimenter un consommateur (17), le moyen de commutation prenant la forme d'un relais.

6. PHS selon la revendication 4, dans lequel la commande (15) comporte un moyen de commutation destiné à être commandé par la PWM pour recharger une batterie (16) et/ou alimenter un consommateur (17), le moyen de commutation prenant la forme soit d'un transistor bipolaire, soit d'un transistor à effet de champ, soit d'un MOSFET.

7. PHS selon la revendication 6, dans lequel la longueur de pause entre impulsions de la PWM est configurée pour s'inscrire entre 1 (une) milliseconde et 1000 millisecondes.

8. PHS selon l'une quelconque des revendications précédentes, dans lequel un capteur thermique est agencé avec la batterie rechargeable (16) dans le but de déterminer la température de la batterie et fournir une entrée à la commande.

9. PHS selon l'une quelconque des revendications précédentes, dans lequel la commande est configurée pour déterminer une valeur de la PWM de manière à fournir un courant de charge à la batterie rechargeable (16) sur la base de la température de la batterie (16) et de valeurs de charge admissibles préconfigurées correspondantes affectées à la température de la batterie, les valeurs de charge admissibles étant stockées avec la commande (15).

10. PHS selon l'une quelconque des revendications précédentes, dans lequel le consommateur électrique (17) prend la forme d'un ou de plusieurs éléments chauffants résistifs pour la dissipation de la puissance électrique et la conversion de la puissance électrique en chaleur.

11. PHS selon la revendication 10, dans lequel l'élément chauffant résistif est positionné au sein du PHS pour chauffer l'un des éléments suivants :
- l'entrée d'air (2,3) ;
- le réservoir de combustible ;
- la pompe à combustible ;
- l'entrée de combustible dans la pompe à combustible ;
- le moteur pour le ventilateur de combustion (11) ;
- la pompe de circulation (si le milieu caloporteur est à base de liquide) ;
- un réservoir d'eau tampon pour l'eau chauffée (si le milieu caloporteur est à base de liquide) ;
- le moteur pour le ventilateur d'air (10) (si le milieu caloporteur est à base d'air) ;
- la batterie rechargeable (16).

12. PHS selon l'une quelconque des revendications précédentes, dans lequel la commande (15) est adaptée à surveiller la température de la batterie rechargeable (16) et, dans le cas où la température de la batterie rechargeable dépasse une valeur prédéterminée, déconnecter un élément chauffant agencé avec la batterie pour éviter une surchauffe de la batterie rechargeable (16).

13. PHS selon l'une quelconque des revendications précédentes, dans lequel le consommateur électrique (17) est une pince qui sert à court-circuiter l'au moins un module thermoélectrique (13) et dissiper la puissance électrique générée par l'au moins un module thermoélectrique (13) dans la résistance interne du module thermoélectrique proprement dit.

14. PHS selon l'une quelconque des revendications précédentes, dans lequel la commande (15) est configurée pour alimenter le moteur pour 1) la pompe à combustible électrique, 2) le ventilateur d'air de combustion ou 3) le ventilateur d'air ou 4) la pompe de circulation avec un courant d'alimentation d'amplitude et de polarisation variables de manière à réguler le moteur sur un rendement non optimal en maintenant toutefois la vitesse voulue de manière à consommer la puissance électrique générée par l'au moins un module thermoélectrique (13) dans le moteur et produire de la chaleur.

15. PHS selon l'une quelconque des revendications précédentes, comprenant en outre un moyen de mesure de la température du côté chaud de l'au moins un module thermoélectrique (13), la commande (15) étant adaptée à surveiller le niveau de température du côté chaud de l'au moins un module thermoélectrique (13) et, dans le cas où le niveau de température dépasse une valeur seuil de température, la commande (15) réagissant en augmentant l'appel de courant depuis l'au moins un module thermoélectrique jusqu'à ce que le niveau de température du côté chaud se situe au-dessous de la valeur seuil de température et, dans le cas où une valeur seuil maximale pour l'appel de courant est atteinte et où le niveau de température continue de dépasser la valeur seuil de température, la commande (15) commandant en outre la pompe à combustible dans le but de réduire la quantité de fluide alimentant le brûleur (4) jusqu'à atteindre un état où le niveau de température du côté chaud de l'au moins un module thermoélectrique (13) ne dépasse pas la valeur seuil de température.
